(19) Europäisches Patentamt / European Patent Office / Office européen des brevets

(11) **EP 3 109 875 B1**

(12) **FASCICULE DE BREVET EUROPEEN**

(45) Date de publication et mention
de la délivrance du brevet:
**02.01.2019 Bulletin 2019/01**

(51) Int Cl.:
***H03H 5/12*** *(2006.01)*      ***H01G 7/06*** *(2006.01)*
***H03H 7/01*** *(2006.01)*      *H04B 1/04* *(2006.01)*

(21) Numéro de dépôt: **15193793.5**

(22) Date de dépôt: **10.11.2015**

(54) **PROCEDE DE CONFIGURATION D'UN CONDENSATEUR BST**

KONFIGURATIONSVERFAHREN EINES BST-KONDENSATORS

METHOD FOR CONFIGURING A BST CAPACITOR

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **22.06.2015 FR 1555716**

(43) Date de publication de la demande:
**28.12.2016 Bulletin 2016/52**

(73) Titulaire: **STMicroelectronics (Tours) SAS
37100 Tours (FR)**

(72) Inventeur: **CHARLEY, Sylvain
37390 Mettray (FR)**

(74) Mandataire: **Cabinet Beaumont
4, Place Robert Schuman
B.P. 1529
38025 Grenoble Cedex 1 (FR)**

(56) Documents cités:
**EP-A1- 2 690 795      CN-U- 202 453 426
FR-A1- 3 013 537**

## Description

### Domaine

La présente description concerne de façon générale les circuits électroniques et, plus particulièrement, la commande d'un condensateur dont la valeur est réglable par application d'une tension de polarisation. La présente description s'applique plus particulièrement à la commande de condensateurs de type BST (Baryum-Strontium-Titane)

### Exposé de l'art antérieur

Les condensateurs BST ont été développés essentiellement pour des applications radiofréquence, en particulier pour la téléphonie mobile. Disposer d'un condensateur dont la capacité est ajustable de façon analogique améliore de façon significative les performances en permettant d'adapter le dispositif comportant un tel condensateur à l'environnement extérieur.

Un condensateur BST se présente sous la forme d'un circuit intégré (on désigne également ce type de condensateur par condensateur intégré ajustable). La capacité d'un condensateur BST se règle par la valeur d'un potentiel continu de polarisation qui lui est appliqué, généralement dans une plage allant de quelques volts à quelques dizaines de volts, typiquement entre 2 et 20 volts.

La tension de polarisation d'un condensateur BST est généralement fournie par un circuit de commande dédié, réalisant une conversion numérique-analogique haute tension, c'est-à-dire convertissant un mot numérique de configuration (généralement un octet) en une tension analogique continue à appliquer au condensateur pour fixer sa capacité.

La commande ou configuration d'un condensateur BST souffre aujourd'hui d'imprécision en raison, entre autres, de tolérances de fabrication, de variations liées à la température et de variations liées à l'hystérésis du condensateur.

Le document FR3013537 décrit un circuit de commande d'un condensateur BST, comportant un amplificateur dont une contre-réaction est ralentie par une cellule résistive et capacitive.

Le document CN202453426U décrit un circuit de commande d'un condensateur BST.

Le document EP2690795 décrit un transmetteur radio incluant un condensateur BST.

### Résumé

Un mode de réalisation de la présente description propose un procédé de configuration d'un condensateur BST qui pallie tout ou partie des inconvénients des procédés de configuration usuels.

Un mode de réalisation propose une solution adaptée à tenir compte de variations dues à l'hystérésis du matériau diélectrique du condensateur.

Un mode de réalisation propose un procédé compatible avec les circuits de commande usuels de condensateurs BST.

Ainsi, un mode de réalisation prévoit un procédé de configuration d'un condensateur de capacité réglable par polarisation, à une valeur de consigne, comportant les étapes de :

    (a) injecter un courant constant pour polariser le condensateur ;
    (b) mesurer la tension de polarisation du condensateur à l'issue d'un intervalle de temps ;
    (c) calculer la valeur de la capacité obtenue à la fin de l'intervalle de temps ;
    (d) comparer cette valeur à une valeur souhaitée ;
    (e) répéter les étapes (a) à (d) tant que la valeur calculée est différente de la valeur de consigne ; et

stocker la valeur de la tension de polarisation mesurée comme étant la tension de polarisation à appliquer au condensateur dès que la valeur de capacité calculée est égale à la valeur de consigne.

Selon un mode de réalisation, l'étape de calcul applique la formule suivante :

$$\Delta C = Ic * \Delta T / \Delta V,$$

où Ic représente la valeur du courant constant, et où $\Delta V$ et $\Delta C$ représentent respectivement la variation de la tension mesurée et la variation de capacité entre la fin et le début de l'intervalle de temps $\Delta T$.

Selon un mode de réalisation, la tension initiale est nulle.

Selon un mode de réalisation, la formule devient :

$$C = Ic * \sum \Delta T / Vbias,$$

où C représente la capacité calculée et Vbias la tension mesurée.

Selon un mode de réalisation, l'intervalle de temps est le même pour toutes les occurrences.

Selon un mode de réalisation, l'intervalle de temps varie d'une occurrence à l'autre.

Selon un mode de réalisation, l'amplitude du courant est fonction de la variation de capacité souhaitée.

Selon un mode de réalisation, le sens du courant dépend du sens de variation souhaité pour la valeur de capacité.

Selon un mode de réalisation, l'intervalle de temps est compris 50 et 700 millisecondes.

Selon un mode de réalisation, le courant constant a une valeur comprise entre 10 microampères et 500 microampères.

Selon un mode de réalisation, le procédé est mis en oeuvre à chaque besoin de modification de la valeur du condensateur BST.

Un mode de réalisation prévoit également un circuit de commande d'un condensateur de capacité réglable par polarisation, adapté à la mise en oeuvre du procédé décrit.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est une représentation schématique d'un condensateur BST ;
la figure 2 est un schéma électrique équivalent d'un condensateur de capacité réglable par polarisation ;
la figure 3 est un schéma électrique détaillé d'un exemple de réalisation d'un condensateur de capacité réglable par polarisation ;
la figure 4 illustre, sous forme de blocs, des étapes d'un mode de mise en oeuvre du procédé de configuration d'un condensateur de capacité réglable par polarisation ;
les figures 5A à 5C sont des chronogrammes illustrant la mise en oeuvre du procédé de configuration de la figure 4 ; et
la figure 6 est une représentation simplifiée d'un circuit de commande associé à des condensateurs BST.

Description détaillée

De mêmes éléments ont été désignés par de mêmes références aux différentes figures. Par souci de clarté, seuls les éléments utiles à la compréhension des modes de réalisation qui vont être décrits ont été représentés et seront détaillés. En particulier, la réalisation d'un condensateur BST ainsi que des autres parties du circuit de commande n'ont pas été détaillées, les modes de réalisation décrits étant compatibles avec les réalisations usuelles de condensateurs réglables par application d'une tension de polarisation (par exemple des condensateurs BST) et avec les réalisations usuelles du reste du circuit de commande. De plus, les différentes applications possibles d'un condensateur BST n'ont pas non plus été détaillées, les modes de réalisation décrits étant, là encore, compatibles avec les applications usuelles. Dans la description qui suit, les expressions "approximativement", "environ" et "de l'ordre de" signifient à 10% près, de préférence à 5% près.

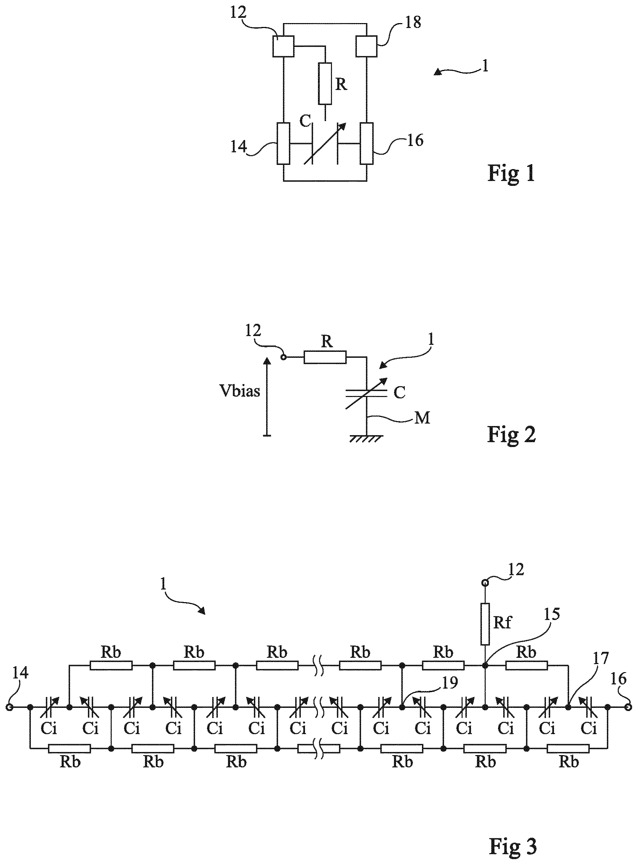

La figure 1 est une représentation schématique d'un circuit intégré 1 formant un condensateur BST. Ce circuit comporte généralement au moins trois bornes 12, 14 et 16. En pratique, pour des questions de réalisation industrielle, le boîtier du circuit intégré peut comporter d'autres bornes 18 non destinées à être connectées. Les bornes 14 et 16 définissent des bornes correspondant aux électrodes du condensateur C destinées à être connectées à l'application radiofréquence. En outre, l'une des bornes 14 et 16 est connectée à la masse. Selon l'application, cette connexion est directe ou (cas d'un condensateur utilisé en série dans la chaine radiofréquence) par l'intermédiaire d'un élément inductif. La borne 12 définit une borne d'application d'un potentiel de polarisation Vbias fixant la valeur de la capacité du condensateur C. D'un point de vue électrique, ce potentiel de polarisation est appliqué par l'intermédiaire d'une résistance R.

La figure 2 représente le schéma électrique équivalent d'un condensateur BST 1. La résistance R d'application de la tension de polarisation Vbias constitue, avec le condensateur C, un circuit RC série entre la borne 12 d'application de la tension Vbias et, dans cet exemple, la masse M.

La figure 3 représente un exemple de schéma électrique détaillé d'un condensateur à capacité réglable par polarisation. Le condensateur 1 comporte plusieurs éléments capacitifs $C_i$ en série, par exemple tous de même valeur. Cette connexion en série est entre les bornes 14 et 16. Le nombre de capacités $C_i$ conditionne la linéarité du condensateur réalisé. Plus ce nombre est important, meilleure est la linéarité du signal radiofréquence, ce signal étant divisé sur l'ensemble des capacités $C_i$. Par exemple, on prévoit entre huit et quarante-huit éléments $C_i$. Des éléments résistifs $R_b$ de polarisation relient les éléments capacitifs $C_i$ deux à deux. Ainsi, pour un nombre n d'éléments capacitifs $C_i$ en série, le condensateur 1 comporte n-1 résistances $R_b$. Bien que cela ne soit pas obligatoire, le nombre d'éléments capacitifs $C_i$ est généralement pair pour optimiser la surface du circuit intégré. Une résistance $R_f$ d'application du signal Vbias relie la borne 12 à une interconnexion entre deux des résistances $R_b$ ainsi qu'au point milieu entre les deux éléments capacitifs $C_i$ au niveau de cette interconnexion. Dans l'exemple de la figure 3, partant de la borne 12, la résistance $R_f$ est connectée entre les troisième et quatrième éléments capacitifs $C_i$, donc au point milieu 15 entre deux résistances $R_b$ qui sont en série entre le point milieu 17 entre les premier et deuxième éléments capacitifs et le point milieu 19 entre les cinquième et sixième éléments capacitifs.

Une difficulté dans la commande ou configuration d'un condensateur BST pour fixer sa valeur est que différents paramètres introduisent des variations de la capacité résultante pour une même tension de consigne. Parmi ces paramètres, on notera les tolérances de fabrication, des variations de la valeur de la capacité en fonction de la température ainsi que des variations liées à l'hystérésis (pour une valeur de consigne donnée, la capacité résultante peut différer selon que l'on augmente ou que l'on diminue la capacité par rapport à la valeur de départ).

On pourrait penser effectuer un asservissement de la tension de consigne en fonction du résultat obtenu dans l'application radiofréquence, par exemple en fonction de la fréquence de coupure obtenue avec la capacité réglable dans cette application. Toutefois, une telle solution serait particulièrement complexe en nécessitant des éléments de mesure au niveau de l'application radiofréquence elle-même. De surcroît, les programmes pour contrôler une telle synchronisation seraient eux aussi particulièrement complexes.

Pour tenir compte des tolérances de fabrication et des variations en température, on pourrait penser intégrer, dans une même puce, le ou les condensateurs BST à commander et leur circuit de commande (en particulier le convertisseur numérique-analogique). Toutefois, cette solution souffre d'un défaut de flexibilité entre le circuit de commande et les condensateurs qui limitent les applications possibles. De plus, cela ne permettrait pas de tenir compte de la variation de la capacité due à l'hystérésis du matériau diélectrique employé.

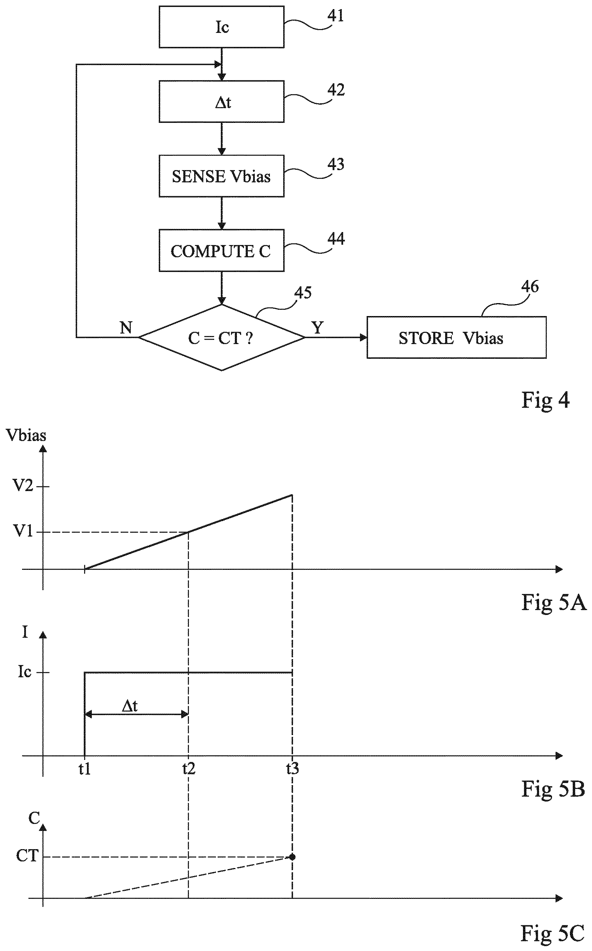

La figure 4 est un schéma bloc illustrant un mode de mise en oeuvre du procédé de configuration de la valeur de la capacité et, plus précisément, de détermination de la tension de polarisation à appliquer pour obtenir la valeur de capacité souhaitée (valeur de consigne).

Les figures 5A, 5B et 5C sont des chronogrammes illustrant la mise en oeuvre du procédé de la figure 4. La figure 5A illustre un exemple de variation de la tension de polarisation Vbias entre la borne 12 et la masse M. La figure 5B illustre l'allure d'un courant I injecté dans le condensateur BST. La figure 5C illustre l'évolution de la valeur de la capacité C obtenue.

Selon le procédé de la figure 4, on prévoit d'injecter (bloc 41, Ic) un courant constant Ic dans le condensateur BST. Ce courant est injecté pendant une période de temps déterminée (bloc 42, $\Delta t$). A l'issue de la temporisation 42, on mesure (bloc 43, SENSE Vbias) la valeur de la tension de polarisation du condensateur BST, c'est-à-dire la valeur de la tension entre les bornes 12 et M.

Sur la base de cette valeur Vbias mesurée, des valeurs du courant Ic et de l'intervalle de temps $\Delta T$ qui sont connues, on calcule alors la capacité obtenue à la fin de la polarisation (bloc 44, COMPUTE C). Cette valeur est calculée par application de la formule suivante :

$$\mathrm{C} \; = \; \mathrm{Ic} \; * \; \Delta \mathrm{T}/\Delta \mathrm{V},$$

où $\Delta V$ représente la variation de tension de polarisation entre la fin et le début de l'application du courant constant.

On compare alors (bloc 45, C = CT ?) la valeur de capacité C obtenue par calcul à la valeur de consigne souhaitée pour cette capacité qui correspond au mot numérique fourni au circuit de commande. Si la valeur souhaitée est atteinte, c'est-à-dire que la valeur mesurée est égale à la consigne souhaitée (sortie Y du bloc 45), on mémorise (bloc 46, STORE Vbias) la valeur de la tension mesurée à l'étape 43 comme étant la valeur de polarisation à appliquer au condensateur BST pour obtenir la capacité désirée. Dans le cas contraire, on revient en entrée du bloc 42 c'est-à-dire qu'on attend un intervalle de temps supplémentaire.

Aux figures 5A et 5C, on suppose une capacité initiale nulle. Le courant constant Ic est appliqué à partir d'un instant t1 et une première mesure est effectuée à un instant t2 postérieur de l'intervalle $\Delta T$. On suppose qu'à cet instant t2, la valeur mesurée V1 de la tension Vbias conduit à un résultat de capacité qui reste inférieur à la capacité CT souhaitée. Le courant Ic continue donc d'être appliqué jusqu'à l'instant ultérieur t3, distant du même intervalle de temps $\Delta T$ dans cet exemple. Aux figures 5A à 5C, on suppose qu'à l'instant t3, la mesure V2 de la tension Vbias conduit à une valeur de capacité atteignant la valeur CT de consigne. On stocke alors cette valeur V2 comme étant la polarisation à appliquer.

Dans la représentation des figures 5A à 5C on a supposé pour simplifier des variations linéaires des différentes grandeurs. On notera qu'en pratique ces variations ne sont toutefois pas linéaires.

Pour le cas où la valeur initiale de la capacité ne soit pas nulle, c'est-à-dire que la variation souhaitée parte d'une valeur de polarisation Vbias non nulle, on tient compte de cette valeur pour calculer la variation de tension $\Delta V$. Il n'est en effet pas nécessaire de ramener systématiquement la capacité à sa valeur nulle. Les calculs peuvent s'effectuer sur des variations de tension $\Delta V$ en calculant :

$$\Delta \mathrm{C} \; = \; \mathrm{Ic} \; * \; \Delta \mathrm{T}/\Delta \mathrm{V},$$

où $\Delta V$ représente la variation de la capacité mesurée entre les deux bornes de l'intervalle de temps $\Delta T$.

En cas de besoin de diminuer la capacité, on applique un procédé similaire à celui décrit ci-dessus avec un courant Ic négatif.

En partant de valeurs initiales nulles pour la tension Vbias et la capacité C, on peut cumuler les intervalles de temps et calculer :

$$\mathrm{C} \; = \; \mathrm{Ic} \; * \; \textstyle\sum \Delta \mathrm{T}/\mathrm{Vbias}.$$

En pratique, la gamme de valeurs du courant Ic est prédéterminée en fonction de la gamme de capacités souhaitée pour l'application. Ce courant Ic est positif ou négatif en fonction de la variation de capacité $\Delta C$ souhaitée. Le courant Ic peut également être ajusté en fonction de cette variation souhaitée $\Delta C$ pour réduire le temps de transition entre la valeur initiale de capacité et la valeur finale. A titre d'exemple particulier, cette valeur peut être comprise entre 10 microampères et 500 microampères. De façon similaire, l'intervalle de temps $\Delta T$ dépend des variations souhaitées au niveau de la capacité en fonction de l'application et également de la granularité souhaitée pour le réglage. Plus l'intervalle de temps est faible, plus la détermination de la capacité est fine mais plus l'application du procédé donc la fixation de la valeur prend du temps. Une durée comprise entre environ 50 et 700 microsecondes constitue un compromis acceptable. L'application du procédé de configuration s'effectue, de préférence, à chaque fois que l'application a besoin d'un réglage de la capacité qu'il s'agisse de fixer une valeur absolue à partir de l'origine ou une variation suite à un changement de configuration dans l'application.

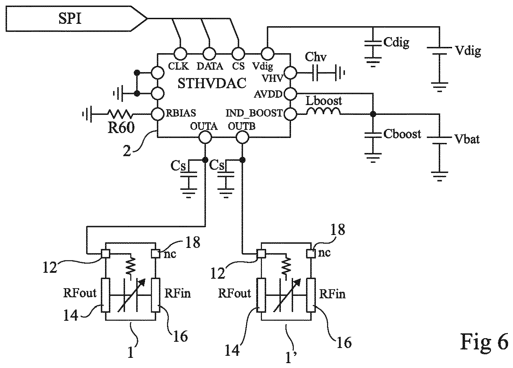

La figure 6 est une représentation schématique d'un circuit de commande 2 de condensateurs réglables par polarisation. Le circuit 6 est basé sur l'emploi d'un convertisseur numérique-analogique haute tension intégré (STHVDAC). Deux tensions, respectivement d'alimentation numérique Vdig (par exemple 1,8 volts) et d'alimentation analogique Vbat (par exemple 3,6 volts) sont appliquées à des bornes Vdig et AVDD du circuit 2. Un élément de filtrage Cdig peut être connecté entre la borne Vdig et la masse. La consigne numérique (mot de données) provient d'autres circuits non représentés de l'application et, dans cet exemple, est fournie par un bus série SPI de trois conducteurs respectivement d'horloge, de données et de synchronisation reliés à des bornes CLK, DATA et CS du circuit 2. Une borne IND_BOOST reçoit la tension Vbat par l'intermédiaire d'un élément inductif Lboost et un condensateur Cboost est connecté en parallèle sur la tension Vbat. Le rôle de ce montage est d'alimenter un étage élévateur de tension générant la tension de polarisation pour commander des condensateurs BST. Dans l'exemple de la figure 6, on suppose deux condensateurs BST 1 et 1' connectés à deux bornes OUTA et OUTB. Une résistance R60 relie une borne RBIAS à la masse et un condensateur Chv relie une borne VHV (recevant la haute tension générée par l'étage élévateur) à la masse. Enfin, un condensateur Cs relie chaque borne OUTA, OUTB à la masse pour stabiliser les tensions de polarisation respectives des condensateurs BST 1 et 1'. D'autres bornes de ce circuit sont susceptibles d'être par ailleurs connectées à la masse. Ces éléments décrits ci-dessus en relation avec la figure 6 constituent des éléments usuels d'un circuit de polarisation de condensateurs BST. La représentation de la figure 6 est un exemple arbitraire et d'autres circuits de commande peuvent s'appliquer au mode de réalisation décrit.

Selon un mode de réalisation, un convertisseur numérique-analogique du type de celui décrit ci-dessus est programmé pour mettre en oeuvre le procédé de configuration. Cette programmation s'effectue, par exemple, par l'intermédiaire d'un microcontrôleur programmé pour communiquer des mots de consigne adaptés à appliquer un courant constant par l'intermédiaire d'une source de courant (non représentée) associée au circuit 2. Ainsi, les modes de réalisation décrits sont compatibles avec les circuits numérique-analogique usuels de commande de condensateurs BST. Par exemple pour une commande en courant, le condensateur BST est en série avec une source de courant constant, activée (par exemple, par l'intermédiaire d'un interrupteur intercalé entre la source de courant et le condensateur) lors d'un besoin de faire varier la capacité. La durée de charge du condensateur par cette source de courant dépend de la variation souhaitée pour la valeur de la capacité.

Un avantage des modes de réalisation décrits est que la précision de la fixation de la valeur de capacité du condensateur BST est améliorée. En particulier, la précision dépend de la précision du circuit de commande mais est rendue indépendante des tolérances de fabrication du condensateur BST, des variations de sa capacité en fonction de la température et de l'hystérésis de son matériau diélectrique. Il est désormais envisageable d'atteindre des précisions de l'ordre du pourcent avec des circuits de commande réalisés en circuit intégré.

Divers modes de réalisation ont été décrits. Diverses variantes et modifications apparaîtront à l'homme de l'art. En particulier, le choix de la valeur du courant constant ainsi que des plages temporelles dépendent de l'application. On notera à cet égard qu'il est également possible de prévoir des plages temporelles variables (par exemple décroissantes au fur et à mesure que l'on s'approche de la valeur de consigne souhaitée pour obtenir un réglage fin). En outre, la mise en oeuvre pratique des modes de réalisation qui ont été décrits est à la portée de l'homme du métier à partir des indications fonctionnelles données ci-dessus.

## Revendications

1.    Procédé de configuration d'un condensateur (1) de capacité (C) réglable par polarisation, à une valeur de consigne, comportant les étapes de :

   (a) injecter (41) un courant constant (Ic) pour polariser le condensateur ;
   (b) mesurer (43) la tension de polarisation (Vbias) du condensateur à l'issue d'un intervalle de temps ($\Delta$T) ;
   (c) calculer (44) la valeur de la capacité (C) obtenue à la fin de l'intervalle de temps, en appliquant la formule suivante :

$$\Delta C = Ic * \Delta T / \Delta V,$$

   où Ic représente la valeur du courant constant, et où $\Delta$V et $\Delta$C représentent respectivement la variation de la tension mesurée et la variation de capacité entre la fin et le début de l'intervalle de temps $\Delta$T ;
   (d) comparer (45) cette valeur à une valeur souhaitée (CT) ;
   (e) répéter les étapes (a) à (d) tant que la valeur calculée est différente de la valeur de consigne ;

et

stocker (46) la valeur de la tension de polarisation mesurée comme étant la tension de polarisation à appliquer au condensateur dès que la valeur de capacité calculée est égale à la valeur de consigne.

2. Procédé selon la revendication 1, dans lequel la tension initiale est nulle.

3. Procédé selon les revendications 1 et 2, dans lequel la formule devient :

$$C = Ic * \sum \Delta T/Vbias,$$

où C représente la capacité calculée et Vbias la tension mesurée.

4. Procédé selon l'une quelconque des revendications 1 à 3, dans lequel l'intervalle de temps ($\Delta$T) est le même pour toutes les occurrences.

5. Procédé selon l'une quelconque des revendications 1 à 3, dans lequel l'intervalle de temps ($\Delta$T) varie d'une occurrence à l'autre.

6. Procédé selon l'une quelconque des revendications 1 à 3, dans lequel l'amplitude du courant (Ic) est fonction de la variation de capacité ($\Delta$C) souhaitée.

7. Procédé selon l'une quelconque des revendications 1 à 6, dans lequel le sens du courant (Ic) dépend du sens de variation ($\Delta$C) souhaité pour la valeur de capacité.

8. Procédé selon l'une quelconque des revendications 1 à 7, dans lequel l'intervalle de temps ($\Delta$T) est compris 50 et 700 millisecondes.

9. Procédé selon l'une quelconque des revendications 1 à 8, dans lequel le courant constant (Ic) a une valeur comprise entre 10 microampères et 500 microampères.

10. Procédé selon l'une quelconque des revendications 1 à 9, mis en oeuvre à chaque besoin de modification de la valeur du condensateur BST.

11. Circuit de commande d'un condensateur de capacité réglable par polarisation, adapté à la mise en oeuvre du procédé conforme à l'une quelconque des revendications précédentes.

**Patentansprüche**

1. Ein Verfahren zum Konfigurieren eines Kondensators (1) mit einer Kapazität (C), die durch eine Vorspannung auf einen Setzpunktwert einstellbar ist, wobei das Verfahren Folgendes aufweist:

(a) Injizieren (41) eines konstanten Stroms (Ic) zum Vorspannen des Kondensators;
(b) Messen (43) der Kondensator-Vorspannspannung (Vbias) am Ende eines Zeitintervalls ($\Delta$T);
(c) Berechnen (44) des Wertes der Kapazität (C), die am Ende des Zeitintervalls erhalten wurde durch Verwendung der folgenden Formel:

$$\Delta C = Ic * \Delta T/\Delta V,$$

wobei Ic den Wert des Konstanten Stroms repräsentiert und wobei $\Delta$V und $\Delta$C jeweils die Veränderung der gemessen Spannung und der Kapazitätsveränderung zwischen dem Ende und dem Beginn des Zeitintervalls $\Delta$T repräsentieren;
(d) Vergleichen (45) des Werts mit einem Soll-Wert (CT);
(e) Wiederholen der Schritte (a) bis (d) solange sich der berechnete Wert von dem Setzpunktwert unterscheidet; und

Speichern (46) des Werts der gemessenen Vorspannspannung als die Vorspannspannung die an den Kondensator angelegt werden soll, sobald der berechnete Kapazitätswert gleich dem Setzpunktwert ist.

2. Verfahren nach Anspruch 1, wobei die anfängliche Spannung null ist.

3. Verfahren nach einem der Ansprüche 1 und 2, wobei die Formel wie folgt ist:

$$C = Ic * \sum \Delta T/Vbias,$$

wobei C die berechnete Kapazität und Vbias die gemessene Spannung repräsentiert.

4. Verfahren nach einem der Ansprüche 1 bis 3, wobei das Zeitintervall ($\Delta$T) für jeden Durchgang derselbe ist.

5. Verfahren nach einem der Ansprüche 1 bis 3, wobei sich das Zeitintervall ($\Delta$T) von einem Durchgang zum Anderen verändert.

6. Verfahren nach einem der Ansprüche 1 bis 3, wobei die Amplitude des Stroms (Ic) eine Funktion der gewünschten Kapazitätsveränderung ($\Delta$C) ist.

**7.** Verfahren nach einem der Ansprüche 1 bis 6, wobei die Richtung des Stroms (Ic) von der Variationsrichtung (ΔC) abhängt, die für den Kapazitätswert gewünscht ist.

**8.** Verfahren nach einem der Ansprüche 1 bis 7, wobei das Zeitintervall (ΔT) in dem Bereich von 50 bis 70 Millisekunden liegt.

**9.** Verfahren nach einem der Ansprüche 1 bis 8, wobei der konstante Strom (Ic) einen Wert in Bereich von 10 Mikroampere bis 500 Mikroampere besitzt.

**10.** Verfahren nach einem der Ansprüche 1 bis 9, das jedes Mal implementiert wird, wenn der Wert des BST Kondensators modifiziert werden muss.

**11.** Eine Schaltung zum Kontrollieren eines Kondensators mit einer durch Vorspannung einstellbaren Kapazität, die geeignet ist zum Implementieren des Verfahrens nach einem der vorhergehenden Ansprüche.

**Claims**

**1.** A method of configuring a capacitor (1) having a capacitance (C) settable by biasing, to a set point value, comprising the steps of:

(a) injecting (41) a constant current (Ic) to bias the capacitor;
(b) measuring (43) the capacitor bias voltage (Vbias) at the end of a time interval (ΔT);
(c) calculating (44) the value of the capacitance (C) obtained at the end of the time interval, by applying the following formula:

$$\Delta C = Ic * \Delta T/\Delta V,$$

where Ic represents the value of the constant current, and where ΔV and ΔC respectively represent the variation of the measured voltage and the capacitance variation between the end and the beginning of time interval ΔT;
(d) comparing (45) this value with a desired value (CT);
(e) repeating steps (a) to (d) as long as the calculated value is different from the set point value; and

storing (46) the value of the measured bias voltage as being the bias voltage to be applied to the capacitor as soon as the calculated capacitance value is equal to the set point value.

**2.** The method of claim 1, wherein the initial voltage is zero.

**3.** The method of claims 1 and 2, wherein the formula becomes:

$$C = Ic * \sum \Delta T/Vbias,$$

where C represents the calculated capacitance and Vbias represents the measured voltage.

**4.** The method of any of claims 1 to 3, wherein the time interval (ΔT) is the same for all occurrences.

**5.** The method of any of claims 1 to 3, wherein the time interval (ΔT) varies from one occurrence to the other.

**6.** The method of any of claims 1 to 3, wherein the amplitude of the current (Ic) is a function of the desired capacitance variation (ΔC).

**7.** The method of any of claims 1 to 6, wherein the direction of the current (Ic) depends on the variation direction (ΔC) desired for the capacitance value.

**8.** The method of any of claims 1 to 7, wherein the time interval (ΔT) is in the range from 50 to 700 milliseconds.

**9.** The method of any of claims 1 to 8, wherein the constant current (Ic) has a value in the range from 10 microamperes to 500 microamperes.

**10.** The method of any of claims 1 to 9, implemented each time the value of the BST capacitor needs to be modified.

**11.** A circuit for controlling a capacitor having a capacitance settable by biasing, capable of implementing the method of any of the foregoing claims.

Fig 1

Fig 2

Fig 3

Fig 4

Fig 5A

Fig 5B

Fig 5C

Fig 6

**RÉFÉRENCES CITÉES DANS LA DESCRIPTION**

**Documents brevets cités dans la description**

- FR 3013537
- CN 202453426 U
- EP 2690795 A